(19) Europäisches Patentamt
European Patent Office
Office européen des brevets

(11) **EP 4 064 678 B1**

(12) **EUROPEAN PATENT SPECIFICATION**

(45) Date of publication and mention
of the grant of the patent:
**29.10.2025 Bulletin 2025/44**

(21) Application number: **21382242.2**

(22) Date of filing: **24.03.2021**

(51) International Patent Classification (IPC):
**H05K 5/00** *(2025.01)* **H04N 23/51** *(2023.01)*
**H04N 23/57** *(2023.01)*

(52) Cooperative Patent Classification (CPC):
**H05K 5/0052; H04N 23/51; H04N 23/57;
H05K 5/006**

(54) **ELECTRONIC DEVICE FOR MOTOR VEHICLES**

ELEKTRONISCHE VORRICHTUNG FÜR KRAFTFAHRZEUGE

DISPOSITIF ÉLECTRONIQUE POUR VÉHICULES À MOTEUR

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**28.09.2022 Bulletin 2022/39**

(73) Proprietor: **Ficosa Adas, S.L.U.
08028 Barcelona (ES)**

(72) Inventors:
• **ABAD GARCÍA, Daniel
08232 Viladecavalls (ES)**

• **ALCALDE, Francisco
08232 Viladecavalls (ES)**

(74) Representative: **ZBM Patents - Zea, Barlocci &
Markvardsen
Rambla de Catalunya, 123
08008 Barcelona (ES)**

(56) References cited:
DE-T5- 112018 004 262    JP-A- 2012 010 274
US-A1- 2016 088 759    US-A1- 2019 191 573

**Description**

The present disclosure relates to electronic devices for motor vehicles and more particularly to camera modules for motor vehicles. A method for assembling said electronic device is also disclosed herein.

**BACKGROUND**

Electronic assemblies comprising housing parts that define an inner space for receiving therein at least one electronics carrier for different purposes are widely used, for example in the automotive industry.

One example of such electronic assembly is a camera module for motor vehicles, for example, a parking camera or electronic/digital rear-view mirrors. The vehicle camera module typically includes a housing assembly that is adapted for housing electronics components therein such as an electronics carrier, a camera lens, an imager or image sensor, etc.

The housing assembly generally comprises a first housing part, also referred to as front housing, and a second housing part, also referred to as back housing. In other cases, the first and second housing parts may be side housing parts arranged to be coupled side by side. The first and second housing parts are attached to each other defining an inner space for receiving therein the above mentioned electronics carrier.

Throughout the present description, in use refers to a condition in which the electronic device such as a vehicle camera assembly is ready for operation, with the first housing part and the second housing part attached to one another.

In order to ensure good image quality, the camera lens and the image sensor should be aligned with respect to each other. It is very important that the camera lens and the image sensor remain both aligned over the service life of the camera module such that optical communication is not lost.

The electronics carrier may be for example a printed circuit board (PCB). In use, the electronics carrier is fitted inside the housing assembly as stated above, arranged between the first housing part and the second housing part with both housing parts being attached to each other by means of, e.g. screws passing through the electronics carrier, as disclosed, for example in WO2006136208A1.

The electronics carrier is fixed to the front housing also through screws. This has been found to be undesirable as it is complex and time consuming in assembly operations.

The application EP19382936, filed by the present applicant, provides alternative means for coupling the electronics carrier to the housing assembly. Specifically, the first housing part and the second housing part are coupled together such that the first housing part contacts at least one portion of a first surface of the electronics carrier and the second housing part contacts at least one portion of a second surface of the electronics carrier.

US20160191863 discloses a camera assembly including a printed circuit board that is supported by a rear housing and a front housing through screws. The front housing defines a lens holder for receiving a lens barrel in the rear housing so as to align with a light sensor.

Attachment of the electronics carrier to a housing part of the housing assembly as disclosed in EP19382936 and US20160191863 has been shown to be advantageous since no screws are required for attaching the electronics carrier to the front housing and assembling processes can be therefore speeded up.

US20190191573 discloses a board holding apparatus that holds an electric circuit board between a first and second cases. The holding apparatus comprises locking parts that lock the first and second cases together in a thickness direction of the electric circuit board. It further comprises a bearing surface formed on the second case and the electric circuit board is contact with the bearing surface part in the thickness direction. A spring is provided formed on the first case generating an elastic force pressing the bearing surface part through the electric circuit board.

However, it has been found that, due to manufacturing tolerances in the first housing part and the second housing part, an over pressure should be applied on the electronics carrier in order to prevent it from being moved as it is fitted to the housing assembly.

In that case, a tightening torque applied by the screws to the housing parts should be reduced in order to prevent the electronics carrier from being damaged.

However, reducing tightening torque has been found not to be a suitable solution since the electronics carrier may become loose and alignment between electronics components inside the housing assembly, such as the camera lens assembly and the image sensor, is not suitably accomplished.

Furthermore, when attaching the first housing part to the second housing part through screws, tightening in a housing part results in a bending moment that leads to the opposite side of the housing part to be flexed and lifted up causing an overpressure on the electronics carrier in particular at edge portions thereof as a result of which contact of housing parts on the electronics carrier is lost and the electronics carrier becomes damaged.

In order to avoid undesirable, uncontrolled deformation of the housing parts when tightening a screw therein, the use of clamps has been also suggested. Such clamps are intended to pre-press the housing parts. Although this approach could avoid deformation of the housing part to a certain extent, provision of clamps is again time-consuming and costly.

It has been also found that reducing the thickness of a housing part results in that it is more easily deformed as it is attached to the other housing part. As a result, damage to the electronics carrier may be reduced. However, when tightening a screw in a housing part, having that reduced thickness, for attachment to the other housing part, the housing part is not deformed in a controlled manner as a result of which the electronics carrier is not securely held between the housing parts.

Other prior art approaches seeking to prevent the electronics carrier from being damaged as the housing parts are attached to each other have been also proposed in the art, such as screwing two or more screws at the same time. This however adds complexity and it is a challenging task not suitable in assembly lines.

A need still remains for electronic devices and more particularly camera modules for motor vehicles in which alignment of parts is properly ensured during use without increasing costs while ensuring proper attachment of housing parts.

## SUMMARY

An electronic device for motor vehicles is disclosed herein. The elements which form part of the present electronic device are described separately in detail below.

Electronic device

The present electronic device may be a vehicle camera module. The present disclosure however finds application in many other devices having a housing assembly adapted to house therein electronic components, optical components, etc.

First housing part and second housing part

The electronic device comprises a first housing part and a second housing part. The first housing part is also referred herein to as front housing, and the second housing part is also referred herein to as back housing.

In use, the first housing part and the second housing part are attached to each other through two or more attaching members. When the first housing part and the second housing part are attached together, an inner space is defined therein for receiving an electronics carrier. In use, the electronics carrier is arranged between the first and second housing parts.

At least one contact portion may be formed protruding from the first housing part for pressing against a first surface of the electronics carrier, in use. At least one contact portion may be formed protruding from the second housing part for pressing against a second surface of the electronics carrier, in use.

Electronics carrier

The electronics carrier may be, for example, a printed circuit board (PCB). In one example, the electronics carrier is a single, rigid PCB, that may comprise other PCBs.

The electronics carrier includes electronics components therein such as an image sensor as described above in the example in which the electronic device is a vehicle camera module. The image sensor is arranged in communication to a camera lens that is attached, e.g. screwed or glued, to the first housing part. Said image sensor, also referred herein to as photosensor or imager, which may be, for example, an RGB sensor for image capturing, is coupled to one surface of the electronics carrier so as to capture an optical image from the exterior.

In use, the electronics carrier is fitted within the housing assembly between the first housing part and the second housing part as described above. In this condition, the electronics carrier is tightly sandwiched there between, and preferably between the above mentioned contact portions that are formed protruding from the first and second housing parts.

The electronics carrier has a second surface or top surface and a first surface or bottom surface. In use, a contact pressure is applied to the first and second surfaces of the electronics carrier by the second and first contact portions of the second and first housing parts respectively. It is preferred that the first and second housing parts are configured to be attached to each other with an interference fit with the first and second housing parts being electrically connected to the electronics carrier.

It may be preferred that the electronics carrier is provided with a conductive material in contact areas for contacting the first housing part and the second housing part. Said contact areas located on the first and/or second surface of the electronics carrier may be electrical conductive material and in electrical connection with the electronics components. The electrical connection is thus ensured between the camera housing and the electronics carrier so as to achieve an effective Faraday Cage.

The first surface of the electronics carrier may carry therein the image sensor. The image sensor is arranged in communication to the lens assembly, this is, the image sensor is aligned with the image sensor.

When the present electronic device is a vehicle camera module, the contact portions are formed extending along a direction of the optical axis of the camera lens or parallel thereto, or perpendicular to said first and second surfaces of the electronics carrier.

Throughout the present description, an optical axis refers to a geometrical longitudinal axis associated with an optical system such as a camera lens that defines a path along which light is propagated.

The electronics carrier may include one or more open notches for positioning the electronics carrier centred within the housing parts. The open notches may be also suitable for receiving attaching members such that they do not pass through the electronics carrier. Thus, in use, the attaching members are arranged passing through open areas of the electronics carrier. This increases useful space in the electronics carrier which is very important since the electronics carrier has an increasing number of electronic components therein. The open notch or notches may be located for example at one or more corners of the electronics carrier and may be a hole, indentation, cut, or incision in an area of the electronics carrier wherein the perimeter of such hole, indentation, cut, or incision is not closed, that is, not completely surrounded by the material of the electronics carrier.

Attaching member

Attachment of the first housing part and the second housing part is accomplished by at least one attaching member as disclosed above. The attaching member is adapted to be at least partially inserted through the first and second housing parts, for example through holes formed therein as it will be described below.

The attaching member may be for example a mounting screw. In other cases, the attaching member may be a bolt, a threaded pin, a non-threaded fastener, combinations thereof, or any other member suitable for attaching the first and second housing parts to each other. One or a plurality of attaching members may be provided as necessary.

The attaching members and the holes in the housing parts where the attaching member are intended to be inserted are configured such that, when the first and second housing parts are attached to each other, the first housing part, in particular the above mentioned contact portion of the first housing part, contacts at least one portion of a first surface of the electronics carrier and the second housing part, in particular the above mentioned contact portion of the second housing part, contacts at least one portion of a second surface of the electronics carrier.

In one example, the attaching member are adapted to tightly clamp the electronics carrier in a direction parallel to an optical axis of the lens assembly, that is, along a vertical axis, or perpendicular to the optical axis or to the first and second surfaces of the electronics carrier.

The attaching member may be adapted to be at least partially inserted into the first housing part and at least substantially fully inserted into the second housing part for attaching both housing parts to each other. This is the case where the attaching member is inserted first through the second housing part. Alternatively, the attaching member may be adapted to be at least partially inserted into the second housing part and at least substantially fully inserted into the first housing part for attaching both housing parts to each other. This is the case where the attaching member is inserted first through the first housing part.

As stated above, one or more holes are formed in one of the first or second housing parts. In particular, it may be preferred that one or more threaded holes are formed in one of the first or second housing parts and one or more blind holes are formed in the other of the first or second housing parts. One or more of said holes are preferably in the form of grooves or slots, e.g. oval or groove-shaped holes, for accommodating possible manufacturing tolerances of the housing parts.

The attaching member may be inserted first into a hole in the second housing part and then screwed into a hole in the first housing part or it can be inserted first into a hole in the first housing part and then screwed into a hole in the second housing part. When the electronic device is a camera module fitted within a bodywork area of the motor vehicle, the first housing part and the second housing part are hidden out of sight so that it does not matter if the attaching member is visible out of the camera module from the point of view of aesthetics.

The attaching member may include a head. The head may have different geometries and/or shapes as required. A contact surface and a non-contact surface may be defined in an underside surface of the attaching member head. The contact surface preferably does not extend over the entire underside surface of the attaching member head, in which case the rest of the underside surface corresponds to said non-contact surface. The contact surface may abut one of the first housing part and the second housing part.

Particularly, when inserting the attaching member through the second housing part, the contact surface of the underside surface of the attaching member head may abut a deforming region arranged in the second housing part, whereas the second portion of the underside surface may not abut the deforming region.

The deforming region may include a protruding portion and/or a weakening line as it will be explained hereinafter. More in particular, when inserting the attaching member through the second housing part, the contact surface of the underside surface of the attaching member head may abut the protruding portion that is part of or attached to the second housing part. The contact between the contact surface of the underside surface and the protruding portion upon applying an external force results in a force that causes the second housing part to be bent towards the first housing part through the deforming region in a controlled manner as it will be explained in detail below.

Protruding portion

An interface is defined in the housing part where the attaching member is first inserted to. This is, if the attaching member is first inserted through the second housing part, then the interface is defined in the second housing part. Alternatively, if the attaching member is first inserted through the first housing part, then the interface is defined in the first housing part. A deforming region is formed in that interface.

Within the meaning of the present disclosure, an interface refers to a surface that forms a common boundary between two parts, in this case two of the first housing part, the second housing part, and the attaching member. Thus, within the meaning of the present disclosure, an interface refers to a plane where two of the first housing part, the second housing part, and the attaching member will come together, meet or contact with each other.

As used herein, the term deforming region refers to a region of the second housing part intended to be deformed or bent. The term deforming region may also refer to an area or element that is capable of causing a deformation of a region of the second housing part. It is to be noted that the second housing part includes at least one deforming region and at least one non-deforming region.

The deforming region formed in the above mentioned interface of the second housing part is intended to cooperate with at least one of the first housing part, the second housing part, and the attaching member.

In a first example of deforming region, it comprises a protruding portion. The protruding portion is formed projecting from the interface. Thus, the protruding portion may be referred to as a portion of the interface that extends higher than the interface itself.

The protruding portion may be formed, for example, by an inclined plane, such that a higher point thereof protrudes or projects from the interface. The protruding portion may have different shapes, for example, projecting substantial perpendicular from the interface. In this case, the protruding portion may not include any inclined plane but it may be arranged lying on a plane parallel to the interface.

The protruding portion may be arranged partially surrounding the attaching member, that is, the protruding portion may be arranged not completely surrounding the attaching member. Thus, the protruding portion may be formed at any position of the interface around the attaching member not encompassing the whole perimeter thereof, that is extending less than 360° around the attaching member, for example around a screw shank.

As stated above, the protruding portion is arranged to contact a contact surface of the underside surface of the attaching member. Before the second housing part is deformed, the protruding portion abuts that contact surface of the attaching member.

Although, as described above, the contact surface is preferred not to extend on the entire underside surface of the attaching member, in which case the remaining surface is the above mentioned non-contact surface of the underside surface of the attaching member, it may be however envisaged a case where the protruding portion completely surrounds the attaching member. In this case, the protruding portion would still have a protruding element projecting thereon.

In any case, the protruding portion includes a portion of the interface that extends higher than the interface itself. Therefore, when inserting the attaching member through the first or second housing parts, the contact surface of the underside surface of the attaching member abuts the protruding portion, not the entire underside surface of the attaching member, with the rest of the underside surface of the attaching member, i.e. the non-contact portion, not being contacted by the protruding portion.

The protruding portion may be located such that a distance to the optical axis is shorter or larger as compared with a distance from the attaching member to the optical axis.

Different locations of the protruding portion in the interface relative to the attaching member may result in a different deformation of the housing part that comprises the deforming region. If the at least one attaching member is first inserted through the second housing part, different locations of the protruding portion in the interface relative to the attaching member may result in a different deformation of the second housing part.

With a deforming region configured as a protruding portion formed in the interface, as the attaching member is inserted into a hole in the first housing part and the second housing part, the protruding portion is first contacted by a portion of the attaching member, for example, a screw head, such that a downward vertical force is applied on the second housing part causing said second housing part to be deformed, flexed or bent.

The protruding portion may be preferably formed integral with one or more of the first housing part, the second housing part, or the attaching member. However, it may be envisaged that the protruding portion is a separate part to be attached to the interface, that is, to at least one of the first housing part, the second housing part, and the attaching member. For example, the protruding portion may be a washer or the like having at least one protruding portion or at least one area of increased thickness formed therein.

The protruding portion may have different geometries and/or shapes as required.

The protruding portion may be made of any suitable material. When the protruding portion is made integral with the first housing part or the second housing part, the protruding portion is made of the same material as that housing part, for example plastics, metal such as aluminium or a zinc aluminium alloy family such as Zamak. Metal parts are preferred due to high thermal conductivity, heat dissipation and electromagnetic compatibility. When the protruding portion is separate part, it may be made of stainless steel, for example.

Many other suitable materials are possible. For example, a protruding portion made on the sealing means is also envisaged. Any material and arrangement for the protruding portion is envisaged as long as it causes the second housing part to be deformed in a controlled manner as it is attached to the first housing part.

The protruding portion may be formed in any location in of the attaching member such as in a screw head, as stated above. In this specific case in which the protruding portion is formed in a screw head, it is preferred that the attaching member, i.e. the screw, is not allowed to rotate relative to the housing parts and it is inserted only by being displaced in order to control bending. It is thus possible to precisely control the position of the protruding portion when attaching both housing parts.

A configuration of the first housing part, the second housing part, and the attaching member is such that the following condition is met:

$$(A + G1) < (B + C + G2)$$

wherein:

- A is a distance between a surface of the first housing part and an end surface of a contact portion of the first housing part;
- B is a thickness of the electronics carrier;
- C is a distance between an end surface of a contact portion of the second housing part and a bottom contact surface of the second housing part;
- G1 is a tolerance distance between the contact surface of the first housing part and a bottom contact surface of the second housing part; and
- G2 is a tolerance distance between a contact portion of the second housing part and a surface of the electronics carrier.

A height of the protruding portion from the interface is preferred to be greater than the distance between the contact surface of the first housing part and the bottom contact surface of the second housing part before deformation.

Weakening line

As stated above, the deforming region may comprise at least one weakening line in addition or alternatively to the protruding portion. That is, the weakening line may be independent of the protruding portion. Thus, the deforming region may comprise at least one protruding portion, or it may comprise at least one weakening line, or it may comprise at least one protruding portion and at least one weakening line.

The weakening line may be defined by a reduced thickness area formed in at least one portion of the first housing part or the second housing part. In particular, if the at least one attaching member is inserted first to the second housing part, the deforming region that includes the weakening line may be provided in the second housing part. Particularly, the thickness reduction area may be formed in at least one portion of the second housing part.

The thickness reduction may be between 0.5 millimetres to 5 millimetres. The preferred thickness reduction may be 2 millimetres. The thickness reduction may be between 5% and 50% of the thickness of the portion of the first housing part or the second housing part where the weakening line is provided. The preferred thickness reduction may be 20% of the thickness.

In particular, the weakening line may be formed in at least one of a surface of the second housing part in the interface defined by a surface of the second housing part arranged to contact a surface of the first housing part, or in a surface of the second housing part in the interface defined by a surface of the second housing part arranged to contact a surface of the attaching member.

Provision of at least one weakening line in the second housing part ensures deformation of the second housing part, when the second housing part is attached to the first housing part, to be located in a specific location thereof. Also, controlled and localized deformation of the second housing part is ensured to take place just along the weakening line and not in other portions of the second housing part.

The weakening line may be provided outside an outer perimeter of the electronics carrier.

The weakening line may be formed in any location between (i) an area where the attaching member applies a pressure to an area of the housing part to be contacted by the head of said attaching member; and (ii) the contact portion that presses against the electronics carrier.

Particularly, the weakening line is intended to be contacted by the attaching member when the first housing part is attached to the second housing part.

It may thus be preferred that the weakening line runs through the centre of the hole in the second housing part where the attaching member is to be inserted. The weakening line may follow a straight or curved path, that is, the weakening line may be formed of one or more straight or curved lines or a combination of straight and curved lines. If the weakening line is formed with two lines, they may be inclined at an angle to each other such as 45° or 90°. Many other arrangements and locations for the weakening lines are possible.

Preferably, the weakening line may include a first end and a second end. The first end of the weakening line is arranged at one side of one of the first and second housing parts, and the second end the weakening line is arranged at another side of said housing part. Preferably, the weakening line is provided in the vicinity of a corner in the first or second housing parts.

The weakening line may define two portions in the first housing part or in the second housing part. A first portion of the weakening line in one housing part is adapted to be deflected towards the other housing part through said weakening line upon applying an external force. A second portion of the weakening line in said housing part is configured not to be deformed. In particular, if the weakening line is provided in the second housing part, the first portion of the weakening line is adapted to be deflected towards the first housing part upon applying an external force. The first portion of the weakening line is located further away from the optical axis than the second portion of the weakening line. A distance between the first portion of the weakening line and the optical axis is greater than a distance between second portion of the weakening line and the optical axis.

In the case where the deforming region comprises at least one protruding portion in combination with at least one weakening line, a downward force by the attaching member to the second housing part results in an upward reaction force from the contact portion of the second housing part. For this reason, it is preferred that in that case the weakening line is formed in any location of the second housing part between or in the vicinity to said downward and upward forces.

Interface

As described above, an interface is defined in the second housing part.

In particular, an interface may be defined by a contact surface of the first housing part arranged to contact a bottom contact surface of the second housing part. In this case, the interface will be referred to as first interface.

Also, an interface may be defined by a top contact surface of the second housing part arranged to contact a contact surface of attaching member. In this case, the interface will be referred to as second interface. The contact surface of the attaching member refers herein to a surface of the attaching member that is opposite a top surface. In the case in which attaching member is a screw, said contact surface of the attaching member corresponds to a bottom surface of the screw head that is opposite a top surface of the screw head where a tool is to be fitted for driving the screw.

The protruding portion described above may be formed in one or more of the first and second interfaces.

Therefore, the protruding portion may be formed in one or more of the locations set out below:

- in the first interface:

  - projecting upwards from a contact surface of the first housing part at a first side of the optical axis facing outwards the first housing part, near an outer edge thereof, to contact a bottom contact surface of the second housing part;
  - projecting upwards from a contact surface of the first housing part at a first side of the optical axis facing inwards the first housing part, away from an outer edge thereof, to contact a bottom contact surface of the second housing part;
  - projecting downwards from the bottom contact surface of the second housing part at a first side of the optical axis facing outwards the first housing part, near an outer edge thereof, to contact the contact surface of the first housing part;
  - projecting downwards from the bottom contact surface of the second housing part at a first side of the optical axis facing outwards the first facing inwards the first housing part, away from an outer edge thereof, to contact the contact surface of the first housing part;

- in the second interface:

  - projecting upwards from a top contact surface of the second housing part, at a first side of the optical axis facing outwards the first housing part, near an outer edge thereof, to contact a contact surface of the screw;
  - projecting upwards from a top contact surface of the second housing part, at a first side of the optical axis facing inwards the first housing part, away from an outer edge thereof, to contact a contact surface of the screw;
  - projecting downwards from a contact surface of the screw at a first side of the optical axis facing outwards the first housing part, near an outer edge thereof, to contact a top contact surface of the second housing part;
  - projecting downwards from a contact surface of the screw at a first side of the optical axis facing inwards the first housing part, away from an outer edge thereof, to contact a top contact surface of the second housing part;

and combinations of one or more of the above.

The deforming region in the interface, whether it is defined in the first interface or in the second interface as described above, is arranged to cooperate with at least one of the first housing part, the second housing part, and the attaching member such that at least one portion of one or more of the first housing part or the second housing part is deformed as the first housing part and the second housing part are being attached together by the attaching member. As a result, the electronics carrier is properly clamped between the first housing part and the second housing part.

Sealing means

Preferably, the present electronic device includes sealing means.

The sealing means may be arranged between the first housing part and the second housing part. The first sealing means are preferred to be arranged surrounding a portion of the attaching member, for example, a screw shank when the attaching member is a screw.

The sealing means may comprise a rubber gasket, an O-ring, a gap filler, or glue as required. The sealing means may comprise a heat conductive material. It may be also preferred that the sealing means are of an elastic and deformable nature.

The sealing means may be also provided outside an outer perimeter of the electronics carrier. It may be preferred that the sealing means are provided between the attaching member and the electronics carrier.

A method for assembling the above electronic device is also disclosed herein. The assembly method comprises placing an electronics carrier on a first housing part with a contact portion of the first housing part contacting a first surface of the electronics carrier. The first and second housing parts are pushed to each other, for example through an external force from a piston device, and screws are tightened such that the electronics carrier is sandwiched and clamped between the contact portions of the first and second housing parts.

As a result, a first portion of the first or second housing parts is not deformed, and a second portion of one of the first and second housing parts which comprises a deforming region is deformed such that said second deformed portion in one of the first and second housing parts is bent towards the other of the first and second housing parts upon applying an external force.

The method may further include one or more of the steps of mounting an image sensor on a first surface of the electronics carrier. As stated above, sealing means may be provided between the first housing part and the second housing part. The method may further include inserting a lens in the first housing part. The method may further include moving a lens to be in alignment together with the image sensor; and preferably curing an adhesive component provided either in a lens or in one portion of the first housing part by at least one of heat or UV light.

A large number of benefits are achieved through the above described configuration.

One important effect achieved is that deformation of the second housing part occurs in a controlled way when attached to the first housing part. As a result, a reduced pressure is applied to the electronics carrier, which is still large enough to suitably attach the electronics carrier with no damage thereon.

Since force from torque applied by the attaching member is at least partially absorbed by the interface of the second housing part such that it is not directly received by the electronics carrier, the electronics carrier is reliably protected from being damaged.

The above also results in that proper alignment between the first and second housing parts, and therefore that of the lens assembly and the image sensor, is ensured and maintained during use without using screws for attaching the electronics carrier to the first housing part.

Therefore, a good camera performance is advantageously ensured.

In addition, the first and second housing parts are properly sealed to each other at least in a watertight manner, allowing electronic parts to be suitably and safely received therein. Water from the outside of the housing assembly is prevented from entering through the attaching members ensuring good performance of the camera components therein. This greatly simplifies assembly operations since rubber gaskets between the attaching members, typically the screw heads, and the housing parts are no longer necessary.

With the present housing assembly, a single sealing in the electronics carrier and the first and second housing parts is sufficient for ensuring good sealing and thus good performance. Furthermore, EMC compliance can be maintained due to reliable electrical attachment between the first housing part and the second housing part and their contact with the electronics carrier.

In addition, heat generated by the PCB is efficiently dissipated due to contact of the first housing part and one side of the PCB and contact of the second housing part and the other side of the PCB. Heat dissipation is carried out more easily and faster than prior art solutions where the PCB is attached to the first housing part by means of screws.

Dissipation of heat generated by the camera electronics is also highly improved by having the first housing part, the electronics carrier, and the second housing part arranged with direct contact with each other in use. Due to such improved heat dissipation, the housing assembly is capable of suitably withstanding great amounts of heat that may be generated by camera electronics components received therein during use. There is thus no need for including expensive thermal conductive particles in the housing parts, such as silver as in prior art housing assemblies in combination with sealing means such as rubber gaskets made of an insulating material.

One important advantage of the present electronic device is that there is no need to use fasteners to fix the electronics carrier to the housing. Only attaching members to attach the first and second housing parts together are required. Further, the electronics carrier is prevented from being damaged due to an overpressure when the first housing part and the second housing part are attached to each other. In addition, heat generated by the electronics carrier is efficiently dissipated due to the contact of the first housing part and one side of the electronics carrier and the contact of the second housing part and the other side of the electronics carrier. Furthermore, electromagnetic interference (EMC) is reduced due to the electrical connection between the electronic components of the electronics carrier and the housing parts. Also, the first and second housing parts act as an electrical shielding achieving thus a more effective Faraday Cage. Finally, a lightweight housing assembly is obtained in which complexity and costs are advantageously reduced. The parts of the present housing assembly can be assembled efficiently and quickly without adversely affecting good performance.

## BRIEF DESCRIPTION OF THE DRAWINGS

Non-limiting examples of the present disclosure will be described in the following, with reference to the appended drawings, in which:

Figure 1 is a general perspective view of the housing assembly of the present electronic device showing the first housing part and the second housing part;

Figure 2 is a cross-sectional view of one example of the present electronic device whose deforming region comprises a protruding portion projecting from the interface in the second housing part at one side of the screw, where the screw is not fully tightened to the housing parts;

Figure 3 is a cross-sectional view of the example of the electronic device in figure 1 where the screw is fully tightened with the resulting deformation of the second housing part;

Figure 4 is a cross-sectional view of another example of the present electronic device in which the protruding portion is formed in an opposite side of the screw, with the screw not fully tightened to the first housing part;

Figure 5 is a cross-sectional view of still a further example of the present electronic device whose deforming region comprises a protruding portion and a weakening line, with no screw and shown in a condition before the screw has been fully tightened to the housing parts;

Figure 6 is a cross-sectional view of the example in figure 6 but showing the deformation of the second housing part after the screw, not shown, has been tightened to the housing parts; and

Figure 7 is an enlarged fragmentary detail view where main dimensions of the present electronic device are shown.

**DETAILED DESCRIPTION OF EXAMPLES**

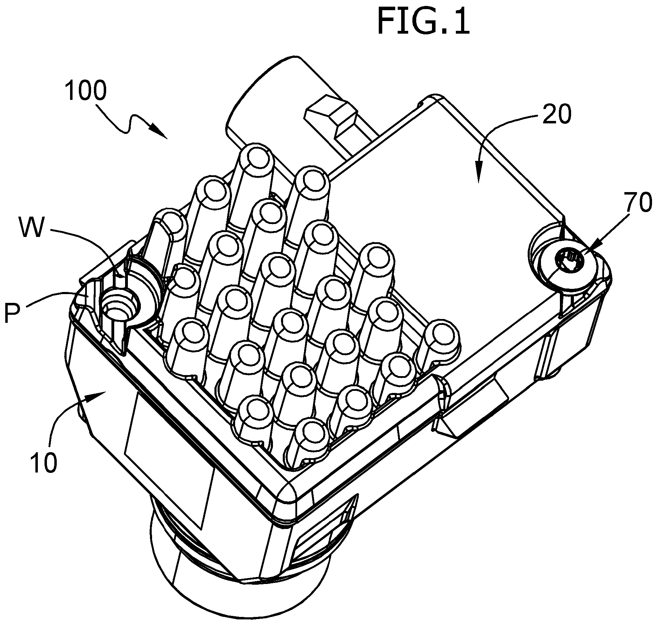

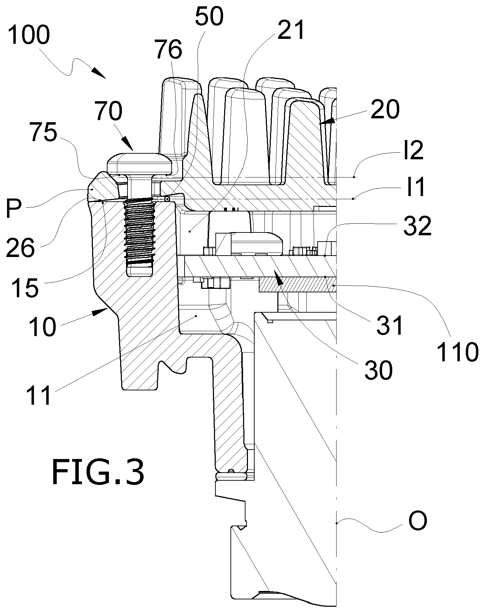

In the examples disclosed herein and shown in the figures 1-7 of the drawings, the electronic device is a vehicle camera module 100.

The vehicle camera module 100 in the examples shown comprises a front housing or first housing part 10 and a back housing or second housing part 20. The first housing part 10 and the second housing part 20 together define a housing assembly. The housing assembly is made for example of an electrically conductive material such as aluminium. Many other materials are possible.

The first housing part 10 and the second housing part 20 are coupled together to define an inner space therein suitable for receiving a PCB 30. In use, the first housing part 10 is coupled to the second housing part 20 with the PCB 30 tightly sandwiched there between.

The electronics carrier in the examples shown comprise a single, rigid printed circuit board (PCB) 30 having a suitable thickness B. The PCB 30 carries therein an image sensor or imager 110. The image sensor 110 is arranged in communication to a lens assembly, not shown, that is attached, e.g. screwed or glued, to the first housing part 10. Said image sensor 110 may be, for example, an RGB sensor for image capturing.

The PCB 30 has a first surface 31 and a second surface 32 for contacting respective contact portions 11, 21 of the first and second housing parts 10, 20 that will be described further below. The image sensor 110 is coupled to the first surface 31 of the PCB 30 so as to capture an optical image from the exterior.

The PCB 30 is also provided with a layer of conductive material arranged on the first surface 31 and the second surface 32 at or near the perimeter thereof where a contact or sandwich area of the PBC 30 with the first and second housing parts 10, 20 is located for the purposes of improving sealing, heat dissipation and EMC compliance.

The first housing part 10 and the second housing part 20 are coupled together through two or more mounting screws 70. However, in other cases, bolts, threaded pins, non-threaded fasteners, combinations thereof, may be used, or any other member suitable for attaching the first and second housing parts 10, 20 to each other.

The mounting screws 70 are intended to be screwed into respective holes formed in opposite corners of the first and second housing parts 10, 20. Specifically, one or more threaded holes are formed in one of the first or second housing parts 10, 20 and one or more blind holes are formed in the other of the first or second housing parts 10, 20. One or more of said holes are preferably in the form of grooves or slots, e.g. oval or groove-shaped holes, for accommodating possible manufacturing tolerances.

The screws 70 may be inserted first into a hole in the second housing part 20 and then screwed into a hole in the first housing part 10 or it can be inserted first into a hole in the first housing part 10 and then screwed into a hole in the second housing part 20.

The vehicle camera module 100 is to be fitted within a bodywork area of a motor vehicle. Thus, the first housing part 10 and the second housing part 20 are hidden out of sight so that it does not matter if the screws 70 are visible out of the vehicle camera module 100.

In the example shown, the screw 70 is arranged with its longitudinal axis perpendicular to the first and second surfaces 31, 32 of the PCB 30, that is, parallel to an optical axis O of the lens assembly. However, there may cases where the screw 70 is arranged with its longitudinal axis parallel to the first and second surfaces 31, 32 of the PCB 30, that is, perpendicular to an optical axis O of the lens assembly.

As the screws 70 are tightened the force between the first housing part 10 and the second housing part 20 is increased resulting in the PCB 30 being suitably sandwiched there between under pressure with a controlled deformation of the second housing part 20.

Controlled deformation of the second housing part 20 accommodates pressure on the first and second surfaces 31, 32 of the PCB 30 while ensures alignment of the first and second housing parts 10, 20. This results in a good performance of the vehicle camera module 100.

At least one contact portion 11 is formed protruding from the first housing part 10 for pressing against the first surface 31 of the PCB 30, in use, and at least one contact portion 21 is formed protruding from the second housing part 20 for pressing against the second surface 32 of the PCB 30, in use. The PCB 30 is thus suitably fitted, in use, between the contact portions 11, 21 of the first and second housing parts 10, 20, respectively. In particular, the contact portions 11, 21 are aligned in such a way that the distance between the contact portion 11 and the optical axis O is the same as or similar to the distance between the contact portion 21 and the optical axis O.

As a result of the contact portion 11 of the first housing part 10 and the contact portion 21 of the second housing part 20, no screws are required passing through the PCB 30 for attachment thereof and a water-tight housing assembly is advantageously obtained.

The first and second surfaces 31, 32 of the PCB 30 in use are pressed by said contact portions 11, 21 of the first and second housing parts 10, 20. Said first and second surfaces 31, 32 of the PCB 30 are made of or contain an electrically conductive material as stated above for enabling electrical connection of the PCB 30 and the first and second housing parts 10, 20. Preferred conducive materials in that first and second surfaces 31, 32 of the PCB 30 are copper, tin, silver, gold, etc. or a combinations thereof. This contributes both to creating a Faraday cage and dissipating heat.

The screw 70 has head where a contact surface 75 and a non-contact surface 76 are defined in an underside surface thereof.

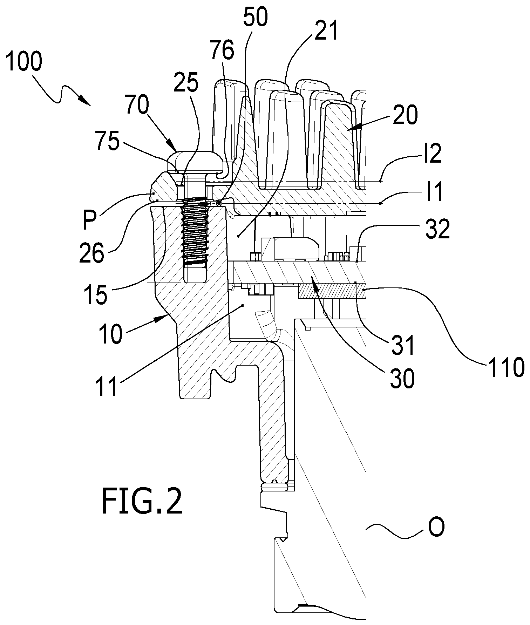

An interface $I_1$, $I_2$ is defined in the second housing part 20. The interface $I_1$, $I_2$ has been depicted in figures 2-3 of the drawings.

The interface $I_1$, $I_2$ may be defined by a contact surface 15 of the first housing part 10 arranged to contact a bottom contact surface 26 of the second housing part 20. In this case, the interface will be referred to as first interface $I_1$.

The interface $I_1$, $I_2$ may be also defined by a top contact surface 25 of the second housing part 20 arranged to contact the above mentioned contact surface 75 in the underside surface in the head of screw 70. In this case, the interface will be referred to as second interface $I_2$.

A deforming region P; W is formed in the interface $I_1$, $I_2$. The deforming region P; W is intended to cooperate with at least one of the first housing part 10, the second housing part 20, and the screw 70 as it will explained below.

In the examples shown in the figures 1-7 of the drawings, the deforming region comprises at least one protruding portion P. In the example of figures 1, 5 and 6, the deforming region comprises at least one protruding portion P and at least one weakening line W. Although not shown, cases where the deforming region only comprises one or more weakening lines W, with no protruding portion P, are also envisaged.

In any case, it is preferred that the deforming region P; W is formed passing through a hole formed in the second housing part 20 where the screw 70 is to be inserted.

It is also preferred that the deforming region P; W is delimited by at least two sides of the second housing part 20, as shown in figure 1, where the deforming region P; W is formed at one corner region of the second housing part 20. In practice, two opposite deforming regions are formed in the entire second housing part 20 at opposite corner regions thereof between which a non-deforming region is defined.

Now referring to the case where the deforming region is a protruding portion P, said protruding portion P is a portion of the interface $I_1$, $I_2$ defined in the second housing part 20 that projects from that interface $I_1$, $I_2$.

The protruding portion P is formed integral with one or more of the first housing part 10, the second housing part 20, or the screw 70.

Although, in the examples shown, the protruding portion P includes an inclined plane, it may be preferred that the protruding portion P projects substantially perpendicular to the interface $I_1$, $I_2$, that is, with the protruding portion P not included in an inclined plane but defining a surface that is at least substantially parallel with respect to the interface $I_1$; $I_2$.

The protruding portion P in the examples shown partially surrounds the shank of the screw 70 extending less than 360° there around.

In the example shown in figures 2, 3 and 5-6, the protruding portion P is located such that a separation distance from the protruding portion P to the optical axis O is longer than a separation distance from the screw 70 to the optical axis O. In this case, the protruding portion P is formed to the left of the screw 70 as shown in figures 2, 3 and 5-6 of the drawings.

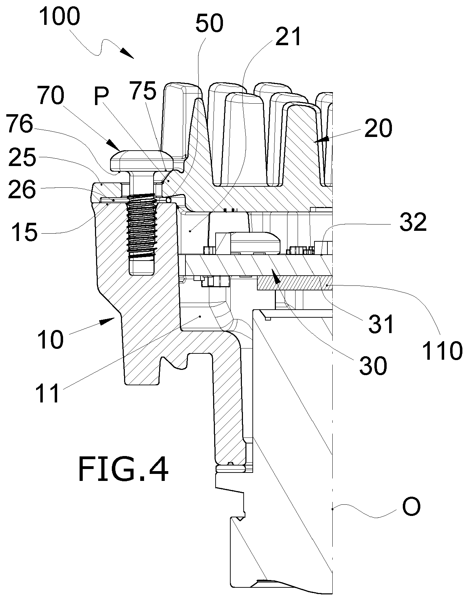

On the other hand, in the example shown in figure 4, the protruding portion P is located such that a separation distance from the protruding portion P to the optical axis O is shorter than a separation distance from the screw 70 to the optical axis O. In this case, the protruding portion P is formed to the right of the screw 70 as shown in figure 4.

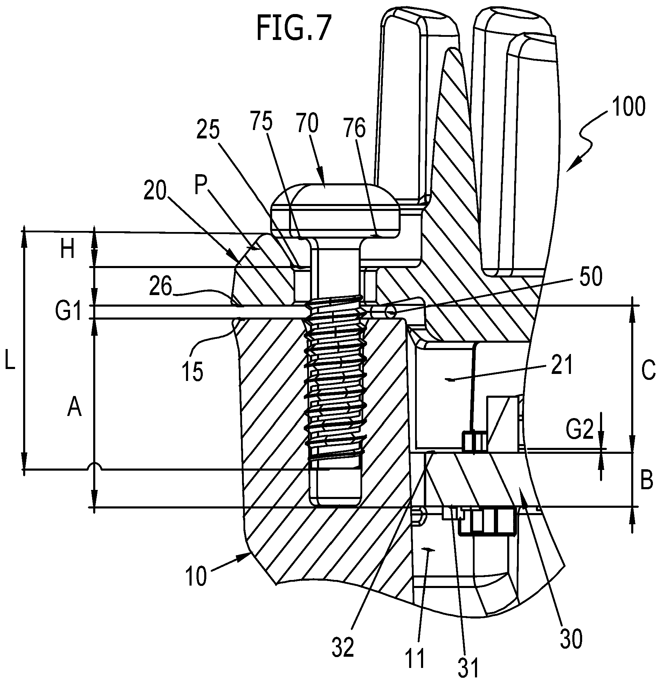

In the specific non-limiting examples shown in figures 2-7 of the drawings, the protruding portion P is formed in the second interface $I_2$ projecting upwards from a top contact surface 25 of the second housing part 20 as shown in detail in figure 7.

In the above mentioned case shown in the figures of the drawings where the screw 70 is arranged parallel to the optical axis O that is, perpendicular to the PCB 30, as the screw 70 is tightened to attach the first and second housing parts 10, 20 to each other, the protruding portion P first comes into contact with the above mentioned contact surface 75 of the head of the screw 70, but it does not come into contact with the non-contact surface 76 of the screw 70. A downward vertical force is applied on the second housing part 20 causing it to be deformed, flexed, or bent in a controlled manner as it is attached to the first housing part 10 until the contact surface 15 of the first housing part 10 contacts the bottom contact surface 26 of second housing part 20. The non-contact surface 76 of the screw 70 might not abut the top contact surface 25 of second housing part 20 where no protruding portion P is present.

Deformation of the second housing part 20 may even continue as the screw 70 is tightened as long as foreign matter is prevented from entering the vehicle camera module 100. In particular, deformation of the second housing part 20 may continue until the non-contact surface 76 of the screw 70 contacts a region of the top contact surface 25 of second housing part 20 other than the protruding portion P.

Deformation of the second housing part 20 still may continue depending on a length L of the screw 70 that is inserted into the hole formed in the first housing part 10. This allows deformation to be suitably controlled.

Of course when the contact surface 75 of the screw 70 is not contacted by the protruding portion P, no deformation of the second housing part 20 occurs. As stated above, deformation of the second housing part 20 starts when a vertical downward force is exerted by the contact surface 75 of the screw 70 on the second housing part 20 as the screw 70 is tightened.

Deformation of second housing part 20 ends when the bottom contact surface 26 of second housing part 20 contacts the contact surface 15 of the first housing part 10. Alternatively, deformation of second housing part 20 may end when the bottom contact surface 26 of the second housing part 20 does not contact the contact surface 15 of the first housing part 10 but the non-contact surface 76 of the screw 70 contacts the bottom contact surface 25 of second housing part 20.

With reference to figure 7 of the drawings, a configuration of the first housing part 10, the second housing part 20, and the attaching member 30 is such that:

$$(A + G1) < (B + C + G2),$$

and

$$H > G1$$

wherein:

A is a distance between an end surface of the first contact portion 11 of the first housing part 10 and the contact surface 15 of the first housing part 10;
B is a thickness of the PCB 30;
C is a distance between an end surface of the contact portion 21 of the second housing part 20 and the bottom contact surface 26 of the second housing part

20;
G1 is a tolerance distance between the contact surface 15 of the first housing part 10 and the bottom contact surface 26 of the second housing part 20 before deformation;
G2 is a tolerance distance between the second contact portion 21 of the first housing part 10 the second surface 32 of the PCB 30; and
H is a height of the protruding portion P from the interface $I_1$, $I_2$.

In an ideal case in which the highest injection molding accuracy is possible for manufacturing the housing parts 10, 20, and the PCB 30, the tolerance distances G1 and G2 would be zero millimeters. However, in practice, both the first housing part 10, the second housing part 20, and the PCB 30 are manufactured with dimensions that differ from the nominal or ideal dimensions so that in practice tolerance distances G1, G2 are greater than zero millimeters. In practice, tolerance distance G1 is set by oversizing dimension C, that is, by oversizing a distance between the end surface of the contact portion 21 of the second housing part 20 and the bottom contact surface 26 of the second housing part 20.

When the contact portion 11 of the first housing part 10 is longer than the nominal distance C between the bottom contact surface 26 of the second housing part 20 and the contact portion 21 of the second housing part 20, within permissible manufacturing tolerances, the contact portion 11 of the of the first housing part 10 in use contacts the first surface 31 of the PCB 30 pressing thereon so that tolerance distance G2 is 0 mm but tolerance distance G1 is greater than 0 mm due to said manufacturing tolerances.

The goal here is to press both the first and second surfaces 31, 32, of the PCB 30 by the contact portions 11, 21 of the first and second housing parts 10, 20, respectively, in a suitable way so that the PCB 30 remains properly sandwiched between the first and second housing parts 10, 20 duly clamped there between.

Therefore, the contact portion 21 of the second housing part 20 is always in abutting contact with the second surface 32 of the PCB 30 due to localized and controlled deformation of the second housing part 20. The second housing part 20 can be thus manufactured with an oversized distance C to be long enough to contact the second surface 32 of the PCB 30 such that tolerance distance G2 is 0 mm and G1 has a suitable small value.

As the screw 70 is screwed through the second housing part 20 into a hole in the first housing part 10, the second housing part 20 and the first housing part 10 move closer to one another such that distance G1 between the contact surface 15 of the first housing part 10 and the bottom contact surface 26 of second housing part 20 is reduced. Deformation of the second housing part 20 is such that the contact surface 15 of the first housing part 10 will contact the bottom contact surface 26 of second housing part 20.

Contact between said contact surfaces 15, 26 of the first and second housing parts 10, 20 respectively is preferred but not essential as long as sealing means 50 are arranged between said the contact surfaces 15, 26. The sealing means 50 will be described further below and are intended to prevent foreign matter such as dirt, liquid, etc. from entering through distance G1 into the inner space of the camera assembly 100 where the PCB 30 is provided.

Since the protruding portion P may be formed in one or more of the first interface $I_1$ and second interface $I_2$, as defined above, many suitable locations for the protruding portion P are possible, which are outlined below.

If the protruding portion P is formed in the first interface $I_1$, the protruding portion P may project upwards from a contact surface 15 of the first housing part 10 at a first side of the optical axis O facing outwards the first housing part 10 (near an outer edge thereof, to the left of the screw 70 in the figures), to contact a bottom contact surface 26 of the second housing part 20. As stated above, this example is shown in figures 2, 3 and 5-6 of the drawings.

Also if the protruding portion P is formed in the first interface $I_1$, the protruding portion P may project upwards from a contact surface 15 of the first housing part 10 at a second side of the optical axis O facing inwards the first housing part 10 (away from an outer edge thereof, to the right of the screw 70 in the figures), to contact a bottom contact surface 26 of the second housing part 20. As stated above, this example is shown in figure 4 of the drawings.

It is to be noted that in the above example where the protruding portion P formed to the right of the screw 70, as shown in the figure 4 of the drawings, the bending moment resulting from tightening of the screws 70 into the first and second housing parts 10, 20 occurs at an opposite direction with respect to the bending moment when the protruding portion P is formed to the left of the screw 70, as in the example shown in figures 2, 3 and 5, 6. Deformation is therefore different depending on where the protruding portion P is formed in the interfaces $I_1$, $I_2$.

When the protruding portion P is formed in the first interface $I_1$, the protruding portion P may project downwards from the bottom contact surface 26 of the second housing part 20 at a first side of the optical axis O facing outwards the first housing part 10 (near an outer edge thereof, to the left of the screw 70 in the figures), to contact the contact surface 15 of the first housing part 10.

With the protruding portion P also formed in the first interface $I_1$, the protruding portion P may project downwards from the bottom contact surface 26 of the second housing part 20 at a second side of the optical axis O facing outwards the first facing inwards the first housing part 10 (away from an outer edge thereof, to the right of the screw 70 in the figures), to contact the contact surface 15 of the first housing part 10;

If the protruding portion P is formed in the sec-ond interface $I_2$ as shown in figures 2, 5, 6, 7 it may project upwards from a top contact surface 25 of the second housing part 20, at a first side of the optical axis O facing outwards the first housing part 10 (near an outer edge thereof, to the left of the screw 70 in the figures), to contact a contact surface 75 of the screw 70.

Also if the protruding portion P is formed in the second interface $I_2$ as shown in figure 4, it may project upwards from a top contact surface 25 of the second housing part 20, at a second side of the optical axis O facing inwards the first housing part 10 (away from an outer edge thereof, to the right of the screw 70 in the figures), to contact a contact surface 75 of the screw 70.

When the protruding portion P is formed in the second interface $I_2$, it may project downwards from a contact surface 75 of the screw 70 at a first side of the optical axis O facing outwards the first housing part 10 (near an outer edge thereof, to the left of the screw 70 in the figures), to contact a top contact surface 25 of the second housing part 20.

With the protruding portion P formed in the second interface $I_2$, it may project downwards from a contact surface 75 of the screw 70 at a second side of the optical axis O facing inwards the first housing part 10 (away from an outer edge thereof, to the right of the screw 70 in the figures), to contact a top contact surface 25 of the second housing part 20.

Combinations of one or more of the above locations for the protruding portion P are possible.

The deforming region P, whether it is formed the first interface $I_1$ or in the second interface $I_2$ as described above, is arranged to cooperate with at least one of the first housing part 10, the second housing part 20, and the screw 70 such that at least one portion of one or more of them is deformed in a localized and controlled manner as the first housing part 10 and the second housing part 20 are attached together by the screw 70. The PCB 30 can be thus properly clamped between the first and second housing parts 10, 20, sandwiched between the end faces of the contact portion 11 of the first housing part 10 and the contact portion 21 of the second housing part 20.

As stated above, in the example of figures 1, 5 and 6 of the drawings, the deforming region comprises a weakening line W in addition to the protruding portion P.

The weakening line W is a portion in the inter-face $I_1$, $I_2$ that is defined in the second housing part 20 as with the protruding portion P.

The weakening line W is a reduced thickness area formed in one or both contact surfaces 25, 26 of the second housing part 20. The reduced thickness may be on the top contact surface 25 and/or on the bottom contact surface 26 of the second housing part 20. The thickness reduction may be between 0.5 millimetres to 5 millimetres. A preferred thickness reduction may be 2 millimetres. The thickness reduction may be between 5% and 50% of the thickness of the portion of the second housing part where the weakening line W is provided. A preferred thickness reduction may be 20%. There may be cases in which the weakening line W is a reduced thickness area of the first housing part 10.

In the non-limiting examples shown, the top and bottom contact surfaces 25, 26 of second housing part 20 are positioned spaced apart from each other by a distance of 1 mm.

The weakening line W may be formed at any portion in the interface $I_1$, $I_2$ extending from a first end located at one side of the second housing part 20 to a second end located at another side of the second housing part 20. More specifically, the weakening line W is formed at opposite edges of the second housing part 20 at any portion in the interface $I_1$, $I_2$ in correspondence with holes for receiving the screws 70 between a point located farthest from the contact surface 75 of the screw 70, and thus from the optical axis O, and a point located in the vicinity of the contact surface 75 of the screw 70, and thus from the optical axis O, at a pressure area thereof.

Thus, deformation occurs according to the weakening lines W in opposite corners of the second housing part 20 with the second housing part 20 being bent towards the first housing part 10. It is also possible that deformation occurs according to the weakening lines W in opposite corners of the second housing part 20 with the first housing part 10 being bent towards the second housing part 20.

The provision the weakening line W ensures deformation of the second housing part 20 as it is attached to the first housing part 10. Such deformation of the second housing part 20 is ensured to take place just along the weakening line W and not in other portions of the second housing part 20. As a result, the second housing part 20 is advantageously deformed, bent or flexed in a localized and controlled manner.

When the first housing part 10 is attached to the second housing part 20, the weakening line W is contacted by the screw 70. For this purpose, the weakening line W is arranged preferably running through the centre of the hole in the second housing part 20 where the screw 70 is to be inserted as described above.

In the example shown, the weakening line W follows a straight path but it may be formed of one or more straight or curved lines or a combination of straight and curved lines. If the weakening line is formed with two lines, they may be inclined at an angle to each other such as 45° or 90°. Many other arrangements and locations for the weakening lines are possible.

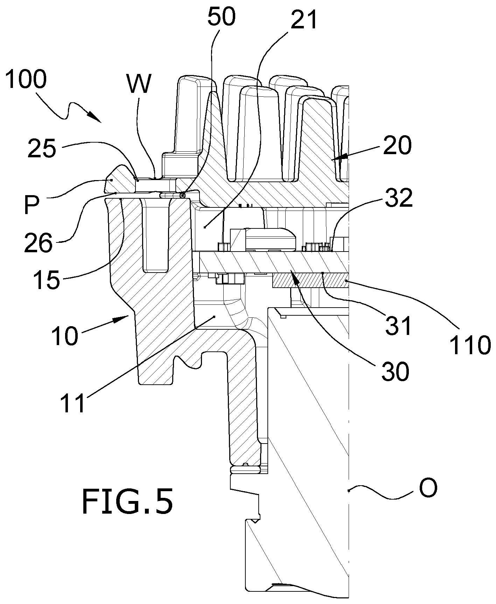

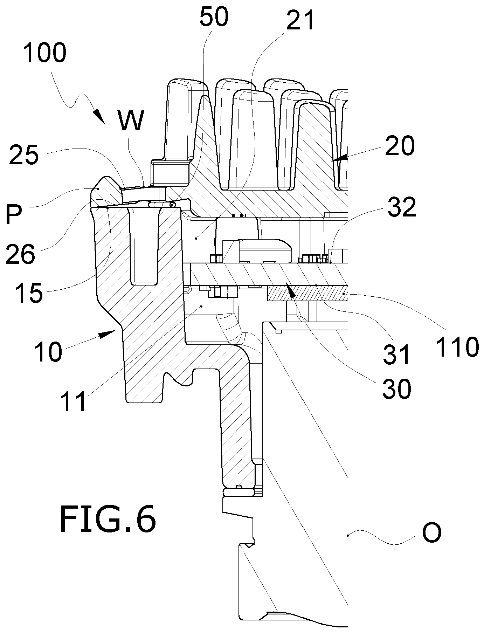

In the example of figures 5 and 6 where the deforming region comprises at least one protruding portion P in combination with at least one weakening line W, when a force applied by the screw 70 is a downward force and the reaction force from the protruding portion P in a housing part 10, 20 is an upward force it is preferred that the weakening line W is formed in any location between said downward force and upward force, between the screw 70 and the housing part 10, 20.

In general, it is preferred that the weakening line W is formed in an area where the screw 70 applies a pressure to an area of the second housing part 20 to be contacted by the head of the screw 70. This ensures that the weakening line W will be deformed, flexed or bent in a localized and controlled manner.

Sealing means 50, such as rubber gasket, thermal pad, glue, gap filler, or the like are provided between the holes for the screws 70 and the PCB 30. In general, it is preferred that the sealing means 50 comprise a heat conductive material of an elastic and deformable nature.

In use, the sealing means 50 are arranged on end faces of the contact portion 11 of the first housing part 10 and the contact portion 21 of the second housing part 20.

With the first and second housing parts 10, 20 attached to each other with the PCB 30 in between, the sealing means 50 reliably prevent external elements such as water, moisture, dirt, etc. from entering the vehicle camera module 100. In use, the sealing means 50 are pressed in a direction of attachment of the first housing part 10 and the second housing part 20 by a force that is substantially perpendicular to the first and second surfaces 31, 32 of the PCB 30, as stated above. As a result the sealing means 50 are properly fitted and the first and second housing parts 10, 20 are appropriately attached and sealed to each other.

Sealing means may be also provided outside an outer perimeter of the PCB 30 for sealing between the first and second housing parts 10, 20 and also in a contact surface between the first and second housing parts 10, 20 if required. This is advantageous is preventing water from reaching the PCB 30.

The vehicle camera assembly 100 disclosed herein is assembled by placing the second housing part 20 adjacent the first housing part 10, or vice versa, and applying an external pressure on one another such as for example along the optical axis O. Once the holes in both housing parts 10, 20 are properly aligned with each other, screws 70 are partially inserted into the first housing part 10 and substantially fully inserted into the second housing part 20 for attaching both housing parts 10, 20 to each other under an axial force with the PCB 30 sandwiched there between.

Although only a number of examples have been disclosed herein, other alternatives, modifications, uses and/or equivalents thereof are possible. Furthermore, all possible combinations of the described examples are also covered. Thus, the scope of the present disclosure should not be limited by particular examples, but should be determined only by a fair reading of the claims that follow. If reference signs related to drawings are placed in parentheses in a claim, they are solely for attempting to increase the intelligibility of the claim and shall not be construed as limiting the scope of the claim.

**Claims**

**1.** An electronic device (100) comprising a first housing part (10), a second housing part (20), at least one attaching member (70) for attaching the first housing part (10) and the second housing part (20) together, and an electronics carrier (30), whereby, in use, an interface (11; 12) is defined in the housing part where the attaching member (70) is first inserted to, the interface (11; 12) forming a common boundary between the first housing part (10) and the second housing part (20),

**characterized in that** the attaching member (70) is adapted to be at least partially inserted through the first and second housing parts (10, 20), and **in that** a deforming region (P; W) is formed in said interface (11; 12) arranged to cooperate with the first housing part (10), the second housing part (20), or the attaching member (70) such that at least one portion of the first housing part (10) or the second housing part (20) is deformed towards the other of the first and second housing parts (10, 20) as the first housing part (10) and the second housing part (20) are being attached together by the attaching member (70) allowing the electronics carrier (30) to be properly clamped between the first housing part (10) and the second housing part (20).

2. The electronic device (100) of claim 1, wherein the interface (11) is defined by a surface (26) of the second housing part (20) arranged to contact a surface (15) of the first housing part (10).

3. The electronic device (100) of claim 1 or 2, wherein the interface (12) is defined by a surface (25) of the second housing part (20) arranged to contact a surface (75) of the attaching member (70).

4. The electronic device (100) of any of the preceding claims, wherein the deforming region comprises a protruding portion (P) projecting from the interface (11; 12).

5. The electronic device (100) of claim 4, wherein a height (H) of the protruding portion (P) from the interface (11; 12) is greater than a distance between the contact surface (15) of the first housing part (10) and a bottom contact surface (26) of the second housing part (20) before deformation.

6. The electronic device (100) of any of the preceding claims, wherein at least one contact portion (11) is formed protruding from the first housing part (10) for pressing against a first surface (31) of the electronics carrier (30), in use, and at least one contact portion (21) is formed protruding from the second housing part (20) for pressing against a second surface (32) of the electronics carrier (30), in use.

7. The electronic device (100) of claim 6, wherein a configuration of the first housing part (10), the second housing part (20), and the attaching member (30) is such that:

$$(A + G1) < (B + C + G2)$$

wherein:

A is a distance between the surface (15) of the first housing part (10) and an end surface of the contact portion (11) of the first housing part (10);
B is a thickness of the electronics carrier (30);
C is a distance between the surface (26) of the second housing part (20) and an end surface of the contact portion (21) of the second housing part (20);
G1 is a tolerance distance between the surface (15) of the first housing part (10) and the surface (26) of the second housing part (20); and
G2 is a tolerance distance between the contact portion (21) of the second housing part (20) and a surface (32) of the electronics carrier (30).

8. The electronic device (100) of any of the claims 4-7, wherein the protruding portion (P) is arranged partially surrounding the attaching member (70).

9. The electronic device (100) of any of the claims 4-8, wherein the protruding portion (P) comprises a surface that is at least substantially parallel with respect to the interface (11; 12).

10. The electronic device (100) of any of the claims 4-9, wherein the protruding portion (P) is a separate part attached to the interface (11; 12).

11. The electronic device (100) of any of the preceding claims, wherein the deforming region comprises at least one weakening line (W) defined by a reduced thickness area of at least one portion of the second housing part (20).

12. The electronic device (100) of claim 11, wherein the weakening line is formed in at least one of a surface (26) of the second housing part (20) in the interface (11) or a surface (25) of the second housing part (20) in the interface (12).

13. The electronic device (100) of claim 11 or 12, wherein the weakening line (W) is provided outside an outer perimeter of the electronics carrier (30).

14. A method for assembling the electronic device (100) of any of the preceding claims, wherein the method comprises:

- placing an electronics carrier (30) on a first housing part (10) with a contact portion (11) of the first housing part (10) contacting a first surface (31) of the electronics carrier (30);
- pushing the first and second housing parts (10, 20) to each other by tightening attaching members (70) such that the electronics carrier (30) is sandwiched and clamped between the contact portions (11, 21) of the first and second housing parts (10, 20);
- whereby a first portion of the first or second housing parts (10, 20) is not deformed, and a second portion of the second housing part (10, 20) which comprises a deforming region (P, W) is deformed such that said second portion of second housing part (20) is bent towards the first housing part (10).

15. The method of claim 14, wherein it further includes one or more of the following steps:

   - mounting an image sensor (110) on a first surface (31) of the electronics carrier (30);
   - providing sealing means (50) between the first housing part (10) and the second housing part (20);
   - inserting a lens in the first housing part (10);
   - moving a lens to be in alignment together with the image sensor (110); and
   - curing an adhesive component provided either in a lens or in one portion of the first housing part (10) by at least one of heat or UV light.

**Patentansprüche**

1. Eine elektronische Vorrichtung (100) umfassend ein erstes Gehäuseteil (10), ein zweites Gehäuseteil (20), mindestens ein Befestigungselement (70) zum Befestigen des ersten Gehäuseteils (10) und des zweiten Gehäuseteils (20) aneinander, und einen Elektronikträger (30), wobei im Gebrauch eine Schnittstelle (11; 12) in dem Gehäuseteil definiert ist, worin das Befestigungselement (70) zuerst eingeführt wird, wobei die Schnittstelle (11; 12) eine gemeinsame Grenze zwischen dem ersten Gehäuseteil (10) und dem zweiten Gehäuseteil (20) bildet, **dadurch gekennzeichnet, dass** das Befestigungselement (70) dazu ausgelegt ist, zumindest teilweise durch das erste und das zweite Gehäuseteil (10, 20) eingeführt zu werden, und dass ein Verformungsbereich (P; W) in der Schnittstelle (11; 12) ausgebildet ist und so angeordnet ist, dass er mit dem ersten Gehäuseteil (10), dem zweiten Gehäuseteil (20) oder dem Befestigungselement (70) zusammenwirkt, so dass zumindest ein Abschnitt des ersten Gehäuseteils (10) oder des zweiten Gehäuseteils (20) in Richtung des anderen des ersten und des zweiten Gehäuseteils (10, 20) verformt wird, wenn das erste Gehäuseteil (10) und das zweite Gehäuseteil (20) durch das Befestigungselement (70) aneinander befestigt werden, wodurch ermöglicht wird, dass der Elektronikträger (30) ordnungsgemäß zwischen dem ersten Gehäuseteil (10) und dem zweiten Gehäuseteil (20) geklemmt wird.

2. Die elektronische Vorrichtung (100) von Anspruch 1, wobei die Schnittstelle (11) durch eine Oberfläche (26) des zweiten Gehäuseteils (20) definiert ist, die angeordnet ist, um in Kontakt mit einer Oberfläche (15) des ersten Gehäuseteils (10) zu kommen.

3. Die elektronische Vorrichtung (100) von Anspruch 1 oder 2, wobei die Schnittstelle (12) durch eine Oberfläche (25) des zweiten Gehäuseteils (20) definiert ist, die dazu angeordnet ist, in Kontakt mit einer Oberfläche (75) des Befestigungselements (70) zu kommen.

4. Die elektronische Vorrichtung (100) von einem der vorhergehenden Ansprüche, wobei der Verformungsbereich einen vorstehenden Abschnitt (P) umfasst, der von der Schnittstelle (11; 12) vorsteht.

5. Die elektronische Vorrichtung (100) von Anspruch 4, wobei eine Höhe (H) des vorstehenden Abschnitts (P) von der Schnittstelle (11; 12) größer als ein Abstand zwischen der Kontaktfläche (15) des ersten Gehäuseteils (10) und einer unteren Kontaktfläche (26) des zweiten Gehäuseteils (20) vor der Verformung ist.

6. Die elektronische Vorrichtung (100) von einem der vorhergehenden Ansprüche, wobei mindestens ein Kontaktabschnitt (11) ausgebildet ist, der von dem ersten Gehäuseteil (10) vorsteht, um im Gebrauch gegen eine erste Oberfläche (31) des Elektronikträgers (30) zu drücken, und mindestens ein Kontaktabschnitt (21) ausgebildet ist, der von dem zweiten Gehäuseteil (20) vorsteht, um im Gebrauch gegen eine zweite Oberfläche (32) des Elektronikträgers (30) zu drücken.

7. Die elektronische Vorrichtung (100) von Anspruch 6, wobei eine Konfiguration des ersten Gehäuseteils (10), des zweiten Gehäuseteils (20) und des Befestigungselements (30) so ist, dass:

$$(A + G1) < (B + C + G2)$$

wobei:

   A ein Abstand zwischen der Oberfläche (15) des ersten Gehäuseteils (10) und einer Endfläche des Kontaktabschnitts (11) des ersten Gehäuseteils (10) ist;
   B eine Dicke des Elektronikträgers (30) ist;

C ein Abstand zwischen der Oberfläche (26) des zweiten Gehäuseteils (20) und einer Endfläche des Kontaktabschnitts (21) des zweiten Gehäuseteils (20) ist;

G1 ein Toleranzabstand zwischen der Oberfläche (15) des ersten Gehäuseteils (10) und der Oberfläche (26) des zweiten Gehäuseteils (20) ist; und

G2 ein Toleranzabstand zwischen dem Kontaktabschnitt (21) des zweiten Gehäuseteils (20) und einer Oberfläche (32) des Elektronikträgers (30) ist.

8. Die elektronische Vorrichtung (100) von einem der Ansprüche 4 bis 7, wobei der vorstehende Abschnitt (P) teilweise um das Befestigungselement (70) herum angeordnet ist.

9. Die elektronische Vorrichtung (100) von einem der Ansprüche 4 bis 8, wobei der vorstehende Abschnitt (P) eine Oberfläche umfasst, die zumindest im Wesentlichen parallel in Bezug auf die Schnittstelle (11; 12) ist.

10. Die elektronische Vorrichtung (100) von einem der Ansprüche 4 bis 9, wobei der vorstehende Abschnitt (P) ein separates Teil ist, das an der Schnittstelle (11; 12) angebracht ist.

11. Die elektronische Vorrichtung (100) von einem der vorhergehenden Ansprüche, wobei der Verformungsbereich mindestens eine Schwächungslinie (W) umfasst, die durch einen Bereich mit verringerter Dicke von mindestens einem Abschnitt des zweiten Gehäuseteils (20) definiert ist.

12. Die elektronische Vorrichtung (100) von Anspruch 11, wobei die Schwächungslinie in mindestens einer von einer Oberfläche (26) des zweiten Gehäuseteils (20) in der Schnittstelle (11) oder einer Oberfläche (25) des zweiten Gehäuseteils (20) in der Schnittstelle (12) ausgebildet ist.

13. Die elektronische Vorrichtung (100) von Anspruch 11 oder 12, wobei die Schwächungslinie (W) außerhalb eines Außenumfangs des Elektronikträgers (30) bereitgestellt ist.

14. Ein Verfahren zum Zusammenbauen der elektronischen Vorrichtung (100) von einem der vorhergehenden Ansprüche, wobei das Verfahren Folgendes umfasst:

- Platzieren eines Elektronikträgers (30) auf einem ersten Gehäuseteil (10), wobei ein Kontaktabschnitt (11) des ersten Gehäuseteils (10) in Kontakt mit einer ersten Oberfläche (31) des Elektronikträgers (30) kommt;

- Zusammenschieben des ersten und zweiten Gehäuseteils (10, 20) durch Anziehen von Befestigungselementen (70), so dass der Elektronikträger (30) sandwichartig zwischen den Kontaktabschnitten (11, 21) des ersten und zweiten Gehäuseteils (10, 20) angeordnet und eingeklemmt ist;

- wobei ein erster Abschnitt des ersten oder zweiten Gehäuseteils (10, 20) nicht verformt wird und ein zweiter Abschnitt des zweiten Gehäuseteils (10, 20), welcher einen Verformungsbereich (P, W) umfasst, so verformt wird, dass der zweite Abschnitt des zweiten Gehäuseteils (20) in Richtung des ersten Gehäuseteils (10) gebogen wird.

15. Das Verfahren nach Anspruch 14, wobei es ferner einen oder mehrere der folgenden Schritte beinhaltet:

- Montieren eines Bildsensors (110) auf einer ersten Oberfläche (31) des Elektronikträgers (30);
- Bereitstellen eines Dichtungsmittels (50) zwischen dem ersten Gehäuseteil (10) und dem zweiten Gehäuseteil (20);
- Einsetzen einer Linse in das erste Gehäuseteil (10);
- Bewegen einer Linse, so dass sie zusammen mit dem Bildsensor (110) ausgerichtet ist; und
- Aushärten einer Klebstoffkomponente, die entweder in einer Linse oder in einem Abschnitt des ersten Gehäuseteils (10) bereitgestellt ist, durch mindestens eines von Wärme oder UV-Licht.

## Revendications

1. Un dispositif électronique (100) comprenant une première partie de boîtier (10), une seconde partie de boîtier (20), au moins un élément de fixation (70) pour fixer la première partie de boîtier (10) et la seconde partie de boîtier (20) ensemble, et un support électronique (30), moyennant quoi, lors du fonctionnement, une interface (11 ; 12) est définie dans la partie de boîtier où l'élément de fixation (70) est d'abord inséré, l'interface (11 ; 12) formant une limite commune entre la première partie de boîtier (10) et la seconde partie de boîtier (20),

**caractérisé en ce que** l'élément de fixation (70) est adapté pour être au moins partiellement inséré à travers les première et seconde parties de boîtier (10, 20), et **en ce qu'**une région de déformation (P ; W) est formée dans ladite interface (11 ; 12) agencée de manière à coopérer avec la première partie de boîtier (10), la seconde partie de boîtier (20) ou l'élément de fixation (70) de telle sorte qu'au moins une section de la première partie de boîtier (10) ou de la seconde partie de boîtier (20) est déformée vers l'autre des première et seconde parties de boîtier (10, 20) lorsque la première partie de boîtier (10) et la seconde partie de boîtier (20) sont fixées ensemble par l'élément de fixation (70) permettant que le support électronique (30) soit correctement serré entre la première partie de boîtier (10) et la seconde partie de boîtier (20).

2. Le dispositif électronique (100) de la revendication 1, dans lequel l'interface (11) est définie par une surface (26) de la seconde partie de boîtier (20) agencée pour venir en contact avec une surface (15) de la première partie de boîtier (10).

3. Le dispositif électronique (100) de la revendication 1 ou 2, dans lequel l'interface (12) est définie par une surface (25) de la seconde partie de boîtier (20) agencée pour venir en contact avec une surface (75) de l'élément de fixation (70).

4. Le dispositif électronique (100) de l'une quelconque des revendications précédentes, dans lequel la région de déformation comprend une section en saillie (P) faisant saillie par rapport à l'interface (11 ; 12).

5. Le dispositif électronique (100) de la revendication 4, dans lequel une hauteur (H) de la section en saillie (P) par rapport à l'interface (11 ; 12) est plus grande qu'une distance entre la surface de contact (15) de la première partie de boîtier (10) et une surface de contact inférieure (26) de la seconde partie de boîtier (20) avant la déformation.

6. Le dispositif électronique (100) de l'une quelconque des revendications précédentes, dans lequel au moins une section de contact (11) est formée en saillie par rapport à la première partie de boîtier (10) pour exercer une pression contre une première surface (31) du support électronique (30), lors du fonctionnement, et au moins une section de contact (21) est formée en saillie par rapport à la seconde partie de boîtier (20) pour exercer une pression contre une seconde surface (32) du support électronique (30), lors du fonctionnement.

7. Le dispositif électronique (100) de la revendication 6, dans lequel une configuration de la première partie de boîtier (10), de la seconde partie de boîtier (20) et de l'élément de fixation (30) est telle que :

$$(A + G1) < (B + C + G2)$$

où :

A est une distance entre la surface (15) de la première partie de boîtier (10) et une surface d'extrémité de la section de contact (11) de la première partie de boîtier (10) ;
B est une épaisseur du support électronique (30) ;
C est une distance entre la surface (26) de la seconde partie de boîtier (20) et une surface d'extrémité de la section de contact (21) de la seconde partie de boîtier (20) ;
G1 est une distance de tolérance entre la surface (15) de la première partie de boîtier (10) et la surface (26) de la seconde partie de boîtier (20) ; et
G2 est une distance de tolérance entre la section de contact (21) de la seconde partie de boîtier (20) et une surface (32) du support électronique (30).

8. Le dispositif électronique (100) de l'une quelconque des revendications 4 à 7, dans lequel la section en saillie (P) est agencée entourant partiellement l'élément de fixation (70).

9. Le dispositif électronique (100) de l'une quelconque des revendications 4 à 8, dans lequel la section en saillie (P) comprend une surface qui est au moins essentiellement parallèle par rapport à l'interface (11 ; 12).

10. Le dispositif électronique (100) de l'une quelconque des revendications 4 à 9, dans lequel la section en saillie (P) est une partie séparée fixée à l'interface (11 ; 12).

11. Le dispositif électronique (100) de l'une quelconque des revendications précédentes, dans lequel la région de déformation comprend au moins une ligne d'affaiblissement (W) définie par une zone d'épaisseur réduite d'au moins une section de la seconde partie de boîtier (20).

12. Le dispositif électronique (100) de la revendication 11, dans lequel la ligne d'affaiblissement est formée dans au moins l'une d'une surface (26) de la seconde partie de boîtier (20) dans l'interface (11) ou d'une surface (25) de la seconde partie de boîtier (20) dans l'interface (12).

13. Le dispositif électronique (100) de la revendication 11 ou 12, dans lequel la ligne d'affaiblissement (W) est fournie à l'extérieur d'un périmètre extérieur du support électronique (30).

14. Un procédé d'assemblage du dispositif électronique (100) de l'une quelconque des revendications précédentes, dans lequel le procédé comprend :

- placer un support électronique (30) sur une première partie de boîtier (10) avec une section de contact (11) de la première partie de boîtier (10) en contact avec une première surface (31) du support électronique (30) ;
- pousser les première et seconde parties de boîtier (10, 20) l'une vers l'autre en serrant les éléments de fixation (70) de telle sorte que le support électronique (30) soit pris en sandwich et serré entre les sections de contact (11, 21) des première et seconde parties de boîtier (10, 20) ;
- par lequel une première section des première ou seconde parties de boîtier (10, 20) n'est pas déformée, et une seconde section de la seconde partie de boîtier (10, 20) qui comprend une région de déformation (P, W) est déformée de telle sorte que ladite seconde section de la seconde partie de boîtier (20) est courbée vers la première partie de boîtier (10).

15. Le procédé de la revendication 14, dans lequel il comprend en outre une ou plusieurs des étapes suivantes :

- monter un capteur d'image (110) sur une première surface (31) du support électronique (30) ;
- fournir un moyen d'étanchéité (50) entre la première partie de boîtier (10) et la seconde partie de boîtier (20) ;
- insérer une lentille dans la première partie de boîtier (10) ;
- déplacer une lentille pour qu'elle soit alignée avec le capteur d'image (110) ; et
- durcir un composant adhésif fourni soit dans une lentille soit dans une section de la première partie de boîtier (10) par au moins l'un de la chaleur ou de la lumière UV.

FIG.1

FIG.2

FIG.3

FIG.4

FIG.5

FIG.6

FIG.7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2006136208 A1
- EP 19382936 A
- US 20160191863 A
- US 20190191573 A